# EUROPEAN PATENT APPLICATION

(11) **EP 4 826 405 A1**
(43) Date of publication of application: **21.10.2026**
(21) Application number: 25170264.3
(22) Date of filing: 14.04.2025
(51) Int. Cl.: G01R 33/24

(54) **METHOD AND SYSTEM FOR SIMULTANEOUS MAPPING OF B0 AND B1+ INHOMOGENEITIES IN MRI**

(71) Applicant: Siemens Healthineers AG, 91301 Forchheim (DE)
(72) Inventor: Pato Montemayor, Natalia, 1004 Lausanne (CH); Liebig, Patrick, 91052 Erlangen (DE); Piredda, Gian Franco, 1006 Lausanne (CH); Hilbert, Tom, 1006 Lausanne (CH); Yu, Thomas, 1024 Ecublens (CH)
(74) Representative: Fischer, Michael

(57) **Abstract**

The invention relates to an MRI method (300) and a system (200) for simultaneous mapping of B₀ and B₁⁺ inhomogeneities, said MRI method (300) comprising:
- performing (301), by an MRI system (200), an MRI pulse sequence (10) configured for imaging a biological object (210), said MRI pulse sequence (10) comprising a saturation TurboFLASH data acquisition sequence, hereafter satTFL sequence, for absolute B₁⁺ mapping, wherein said satTFL sequence comprises at least three temporally successive elements, namely
- a first element (110) that is a pre-saturation TurboFLASH element, followed by
- a second element (120) that is a magnetization preparation element, followed by
- a third element (130) that is a magnetization-prepared TurboFLASH element, wherein the first element comprises a flip angle RF excitation pulse β (111), called hereafter the first flip angle pulse, and an associated pre-saturation TurboFLASH readout (112), the second element (120) comprises a RF excitation pulse α (121), and the third element (130) comprises a flip angle RF excitation pulse γ (131), called hereafter the second flip angle pulse, and an associated magnetization-prepared TurboFLASH readout (132) for acquiring a magnetization-prepared image S_{1,0};

characterized in that
- said associated pre-saturation TurboFLASH readout (112) comprises an acquisition of multiple echoes for ΔB₀ mapping, wherein, for each echo, a respective pre-saturation image for ΔB₀ mapping is acquired;
- a ΔB₀ map and a B₁⁺ map of said biological object (210) are determined (303) from said magnetization-prepared image S_{1,0} and said pre-saturation images;
- the ΔB₀ and B₁⁺ maps are outputted (304).

## Description

### Technical Field

The present invention falls within the field of Magnetic Resonance Imaging (MRI) and proposes a system and a method for simultaneous mapping of B₀ and B₁⁺ inhomogeneities in Magnetic Resonance Imaging (MRI).

### Background Art

Ultra-high field (UHF) MRI (i.e. MRI with magnetic field strength ≥ 7T) provides enhanced signal-to-noise ratio (SNR) and resolution compared to lower field strengths MRI. However, at UHF, the increased Larmor frequency of the water protons makes the associated wavelength comparable to the size of the imaged specimen (particularly when imaging brain), which results in interferences that enhance transmission (B₁⁺) field inhomogeneities, resulting in severe signal voids in the acquired images. To address this issue, several techniques have been developed to ensure homogeneous flip angle distributions at UHF, such as designing subject-specific radiofrequency (RF) pulses with dynamic parallel transmission [1]. However, these pulses require additional online mapping of the main magnetic (B₀) and channel-wise B₁⁺ fields, which increases total scan time. While optimized techniques for local B₀ inhomogeneities (ΔB₀) and B₁⁺ mapping exist, they are typically performed separately, increasing sensitivity to motion artifacts, scanner workload, and acquisition time.

It is therefore desired to find a solution for simultaneous, rapid, mapping of B₀ and B₁⁺ inhomogeneities for dynamic parallel transmission optimization, capable of reducing a need for additional scans, as well as to mitigate motion sensitivity, streamline workflows, and decrease overall acquisition times.

### Summary of Invention

An objective of the present invention is to propose a method and a system for simultaneous mapping of B₀ and B₁⁺ inhomogeneities.

This objective is achieved by the measures taken in accordance with the independent claims. Further advantageous embodiments are proposed by the dependent claims.

More precisely, the present invention concerns a method for simultaneous mapping, notably three-dimensional (3D) mapping, of B₀ and B₁⁺ inhomogeneities, the method comprising:
- performing, by an MRI system, an MRI pulse sequence configured for imaging a biological object, said MRI pulse sequence comprising a main data acquisition sequence for absolute B₁⁺ mapping, which is a saturation TurboFLASH data acquisition sequence, called hereafter satTFL sequence, wherein said satTFL sequence comprises at least three temporally successive elements, namely
   - a first element that is a pre-saturation TurboFLASH element, followed by
   - a second element that is a magnetization preparation element, followed by
   - a third element that is a magnetization-prepared TurboFLASH element,
   wherein the first element comprises a flip angle RF excitation pulse β, called hereafter the first flip angle pulse, and an associated pre-saturation TurboFLASH readout, the second element comprises a RF excitation pulse α (i.e. a saturation pulse, preferentially a 90° saturation pulse), and the third element comprises a flip angle RF excitation pulse γ, called hereafter the second flip angle pulse (preferentially, β = γ), and an associated magnetization-prepared TurboFLASH readout for acquiring a magnetization-prepared image S_{1,0} of said biological object for B₁⁺ mapping. Optionally, the satTFL sequence is a Sandwich sequence, i.e. a sequence wherein the first element is temporally separated from the third element by a time interval that is the minimum time interval required for carrying out or performing the second element, or otherwise said, the temporal gap between the first element and the second element is almost 0;
characterized in that
- said associated pre-saturation TurboFLASH readout comprises an acquisition of multiple echoes (i.e. gradient echo (GRE) readouts) for ΔB₀ mapping (ΔB₀ representing the inhomogeneities of B₀), wherein, for each echo, a respective pre-saturation image (i.e. GRE image) is acquired, and wherein the acquired pre-saturation images are used for said ΔB₀ mapping;
- a ΔB₀ map and a B₁⁺ map of said biological object are determined (or calculated or generated or created) from said magnetization-prepared image S_{1,0} and said pre-saturation images;
- the ΔB₀ and B₁⁺ maps are outputted, e.g. on a display.

The present invention proposes thus to modify the satTFL sequence by adding said acquisition of multiple echoes for ΔB₀ mapping in the pre-saturation TurboFLASH element, creating therefore a "modified" satTFL sequence also called hereafter CLUB sequence, wherein "CLUB" stands for "Combined caLcUlation of Biases". In particular, said CLUB sequence becomes a CLUB-Sandwich sequence in the case the satTFL sequence modified according to the invention is a Sandwich sequence.

By "simultaneous mapping", it has to be understood that the images (or contrasts) used for the mapping of B₀ and B₁⁺ inhomogeneities are acquired for a spatial location within the biological object during the very same CLUB sequence, directly one after the other.

The present invention concerns also an MRI system configured for carrying out the steps of the previously described method.

### Description of Embodiments

The present invention proposes a simultaneous mapping, i.e. measurement, of B₀ and B₁⁺ by acquiring, within the so-called CLUB sequence, multiple echoes for B₀ mapping during the first element of the CLUB sequence, and a (classical) magnetization-preparation image S_{1,0} during the third element of the CLUB sequence. A particular case of the CLUB sequence according to the invention is the so-called CLUB-Sandwich sequence. The latter is notably characterized by the fact that the delay time (TD) between the end of the first element and the start of the second element is approximatively 0 s. At the end, the ΔB₀ and the B₁⁺ map represent respectively a map of inhomogeneities of the main magnetic field B₀ and a map of the inhomogeneities of the transmit RF field B₁⁺.

The present invention is particularly relevant in the case of UHF MRI, wherein magnetic field inhomogeneities might result in stronger contrast variations in the MRI images of the biological object compared to contrast variations appearing in lower fields, wherein said contrast variations are not related to features of the tissue of said biological object, and are therefore prone to misinterpretation. In this context of UHF MRI, the knowledge or measurement of ΔB₀ and B₁⁺ inhomogeneities (via the ΔB₀ and B₁⁺ maps according to the invention) makes it possible to correct or to take into account the measured inhomogeneities when reconstructing an MRI image for the biological object. In order to further improve imaging a biological object in UHF MRI, the present invention proposes in particular to use parallel transmission acquisition, hereafter pTx, for imaging said biological object. In this case, the MRI pulse sequence previously described preferentially comprises, preceding the CLUB sequence, a (2D or resp. 3D) coil-cycled multi-channel data acquisition sequence for acquiring a (2D or resp. 3D) relative map of B₁⁺ for each acquisition coil or channel of the MRI system, wherein, for each channel, the method further comprises calculating a respective channel-related B₁⁺ map by scaling said B₁⁺ map (which has been obtained from said magnetization-prepared image S_{1,0} and said pre-saturation images, and which is typically a (2D or resp. 3D) absolute map of B₁⁺ with a transmission fraction factor calculated voxel-wise from the (2D or resp. 3D) relative map of B₁⁺ obtained for the concerned channel. Indeed, each (2D or resp. 3D) relative map shows or measures a relative transmission fraction, i.e. the fraction of the B₁⁺ magnetic field that is measured by the concerned acquisition coil of the MRI imaging system.

According to the present invention, the associated pre-saturation TurboFLASH readout integrates multiple GRE readouts. Preferentially, said associated pre-saturation TurboFLASH readout comprises an acquisition of three, or of at least two, echoes (i.e. GRE images) for said ΔB₀ mapping. Said echoes are preferentially monopolar echoes or bipolar echoes. In particular, the ΔB₀ map is then reconstructed (or calculated or determined) from the phases of the pre-saturation images. Other known in the art methods for estimating the ΔB₀ map from the pre-saturation images might be used.

Preferentially, the B₁⁺ map is an absolute volumetric flip angle map obtained from a ratio of one of said pre-saturation images (e.g. the first (temporally acquired) pre-saturation image) and the magnetization-prepared image S_{1,0} using a lookup table generated from Bloch equations and extended phase graph (EPG) simulations to account for T1 relaxation effects. This technique is known in the art (see for instance Weigel et al. [2]) and does not require additional explanations here.

Preferentially, P dummy CLUB sequences are acquired prior to the CLUB sequence that is used for mapping simultaneously ΔB₀ and B₁⁺, wherein P ≥ 1.

Preferentially, the MRI pulse sequence, notably its CLUB sequence, might be accelerated by using an undersampling technique, e.g. a parallel imaging or compressed sensing method, for generating the pre-saturation images and the magnetization-prepared image S_{1,0}, wherein the ΔB₀ and B₁⁺ maps are then determined from the generated images, which might be reconstructed using known in the art dedicated reconstruction methods, like deep-learning based methods, adapted to the used undersampling technique.

### Brief Description of the Drawing

Further aspects of the present invention will be better understood through the following drawings, wherein like numbers designate like objects:
- Fig. 1: illustration of an MRI pulse sequence diagram according to the invention;
- Fig. 2: schematic illustration of a system according to the invention;
- Fig. 3: flowchart of a preferred embodiment of a method according to the invention;
- Fig. 4: illustration of a mapping of B₀ and B₁⁺ inhomogeneities according to the invention.

### Description of Examples

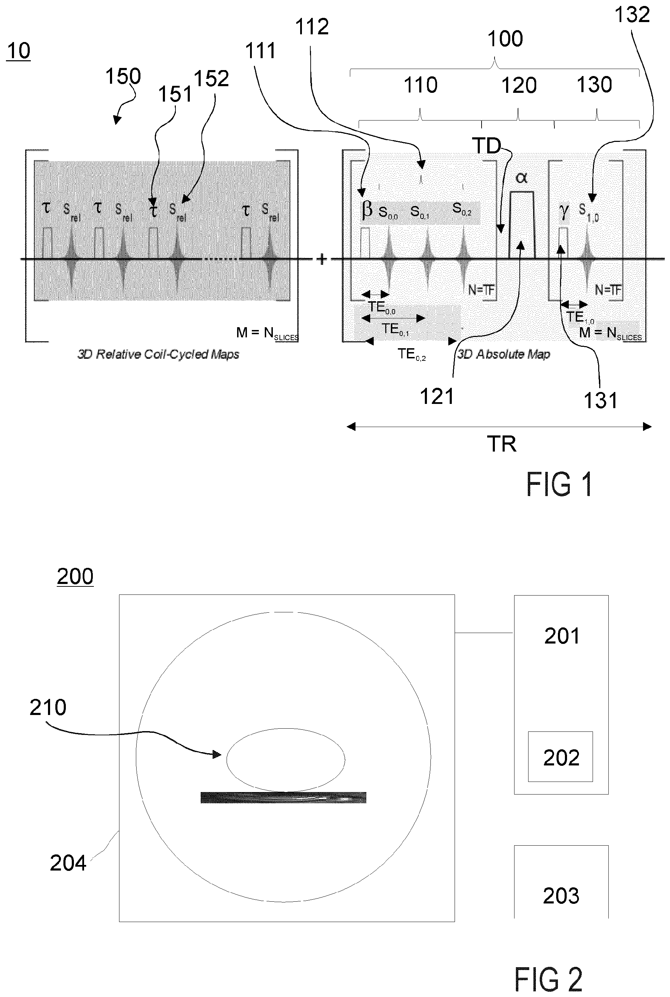

Figure 1 illustrates a diagram of a preferred embodiment of an MRI pulse sequence 10 according to the invention. The illustrated MRI pulse sequence is a modified version of a previously developed MRI pulse sequence used for 3D B₁⁺ mapping, referred to as "Sandwich" [3], and which is itself a modified saturated TurboFLASH sequence, wherein pre-conditioned (or pre-saturation) and magnetization-prepared images "sandwich" a saturation pulse α in a single 3D sequence to further reduce T₁ sensitivity and acquisition time. The MRI pulse sequence 10 according to the invention comprises at least a CLUB sequence 100, which is in the particular case illustrated in Figure 1, a CLUB-Sandwich sequence, for absolute B₀ and B₁⁺ mapping, wherein said CLUB sequence 100 comprises at least three temporally successive elements, namely
- a first element 110 that is a pre-saturation TurboFLASH element, followed by
- a second element 120 that is a magnetization preparation element, followed by
- a third element 130 that is a magnetization-prepared TurboFLASH element.

The first element 110 comprises a flip angle RF excitation pulse β 111, called hereafter the first flip angle pulse β, followed by an associated pre-saturation TurboFLASH readout 112. The latter comprises an acquisition of multiple echoes (i.e. of multiple MRI gradient echo signals) for ΔB₀ mapping. Preferentially, it comprises an acquisition of three monopolar echoes, or otherwise said, of three pre-saturation images S_{0,0}, S_{0,1}, S_{0,2}, wherein each pre-saturation image S_{0,i} corresponds to the MRI gradient echo signal acquired at a time of echo TE_{0,i}, with i=0,...,2. Of course, the pre-saturation TurboFLASH readout 112 may comprise an acquisition of more than 3 pre-saturation images, each at a respective different echo time. Typically, the first flip angle pulse β 112 is a low flip angle pulse characterized by a flip angle lower than 90°, for instance a 5° flip angle. According to the TurboFLASH technique, the first element 110 is characterized by a turbo factor TF, which defines the number N of times said first element 110 is successively repeated, i.e. TF = N. In particular, the time interval between the first flip angle pulse β of two directly successive first elements, called first echo spacing, is comprised between 3 ms and 8 ms.

The second element 120 comprises a RF excitation (saturation) pulse α 121. It is preferentially configured for achieving a broad-band full-passage hyperbolic secant saturation pulse with angle of 90°.

The third element 130 comprises a flip angle RF excitation pulse γ 131, called hereafter the second flip angle pulse, followed by an associated magnetization-prepared TurboFLASH readout 132 for acquiring a magnetization-prepared image S_{1,0} (i.e. an MRI GRE signal) at a time of echo TE_{1,0}. According to Fig. 1, the third element comprises a single echo acquisition for reconstructing the magnetization-prepared image S_{1,0}. However, there is no limitation with respect to the number of echoes that can be acquired during said third element. For instance, multiple echoes could be acquired during the magnetization-prepared TurboFLASH readout 132, wherein the magnetization-prepared image S_{1,0} could be reconstructed from one or several of said echoes (i.e. MRI echo signals) using for instance a weighted contrast calculation. Preferentially, in case of multiple echoes acquired in the third element 130, B₁⁺ is calculated from the first (temporally acquired) echo in the first element and the first (temporally acquired) echo in the third element 130 to avoid undesired T1-related effects. As mentioned above with respect to the TurboFLASH technique, the third element 130 is characterized by said turbo factor TF, which defines said number N of times said third element 130 is successively repeated. In Figure 1, the square brackets within the CLUB sequence 100 indicates indeed a TurboFLASH repetition period for phase encoding. In particular, the time interval between the second flip angle pulse γ of two directly successive third elements, called second echo spacing, is comprised between 1 ms and 4 ms.

As mentioned earlier, the CLUB sequence 100 illustrated in Fig. 1 is a CLUB-Sandwich sequence which is characterized by the fact that the delay time TD between the end of the first element and the start of the second element is approximatively 0 s, i.e. the second element starts (almost) directly at the end of the last pre-saturation TurboFLASH readout 112 of the first element. Preferentially, the first flip angle and the second flip angle are equal, i.e. β = γ. In particular, N is typically comprised between 24 and 38, with N=32 preferentially.

Figure 1 illustrates the CLUB sequence 100 for a single repetition time TR. A series of said CLUB sequences 100 according to the invention might be repeated for imaging a slice of the biological object, wherein the CLUB sequences 100 of said series are separated from each other by said repetition time TR of typically several hundreds of milliseconds, such series being for instance repeated M times by the MRI system for imaging a number N_{SLICES} of slices of the biological object, with N_{SLICES} = M. Of course, the MRI pulse sequence 10, notably the CLUB sequence 100, further comprises additionally known in the art appropriate spatial encoding (namely frequency and phase encoding) by means of magnetic field gradients for imaging each voxel of each slice of the biological object. In particular, the MRI system may run the MRI pulse sequence 10 with 2D or 3D spatial encoding for outputting respectively 2D or 3D ΔB₀ and B₁⁺ maps. In particular, said spatial encoding comprises a linear phase encoding. Optionally, each phase-encoding step and RF pulse might be followed by a RF spoiling.

In particular, notably in the case of UHF MRI, the present invention further proposes to reduce the additional time required for data acquisition used for ΔB₀ and B₁⁺ mapping by accelerating MRI data acquisition as illustrated in Figure 1. Indeed, the MRI pulse sequence 10 according to the invention may additionally comprise a coil-cycled multi-channel data acquisition sequence 150 (for instance a 3D sequence 150 as illustrated in Fig. 1) configured for acquiring (3D) relative maps of the biological object. Said (3D) coil-cycled multi-channel data acquisition sequence 150 is performed by the MRI system according to the invention before the CLUB sequence 100. Optionally, notably in addition to said (3D) coil-cycled multi-channel data acquisition sequence 150, the MRI pulse sequence 10 may comprise one or several dummy scans (not shown) performed by the MRI system prior to the CLUB sequence 100 that is used for mapping of ΔB₀ and absolute B₁⁺ simultaneously. Each dummy scan is an absolute CLUB sequence 100 performed by the MRI system, but for which no MRI signal is collected and processed. Said dummy scans typically take place between the (3D) coil-cycled multi-channel data acquisition sequence 150 and the CLUB sequence 100 illustrated in Figure 1. As for the CLUB sequence 100, the (3D) coil-cycled multi-channel data acquisition sequence 150 is shown in Fig. 1 for a single repetition time. As known in the art, a series of said sequences 150 might be used for imaging a slice, and such series might be repeated M times by the MRI system for imaging said number N_{SLICES} of slices of the biological object, with N_{SLICES} = M. Afterwards, said dummy scans, e.g. two 3D dummy scans in case of 3D spatial encoding, are performed by the MRI system 200 before starting the repetition of the series of CLUB sequences 100 for acquiring the images required for imaging said M slices of the biological object.

The (3D) coil-cycled multi-channel data acquisition sequence 150 comprises, for each MRI acquisition coil or channel of the MRI system, a flip angle RF excitation pulse τ 151, called hereafter the third flip angle pulse, followed by a channel-related MRI readout 152 for acquiring a relative image Sᵣₑₗ (i.e. an MRI echo signal for reconstruction of (3D) relative coil-cycled maps) for that channel or coil, wherein said relative image Sᵣₑₗ shows the relative transmission fraction of the B₁⁺ field that is acquired by said channel or coil. Preferentially, the flip angle of the third flip angle pulse is equal to the flip angle of the first flip angle pulse, for instance β = γ = τ.

Figure 2 illustrates very schematically an MRI system 200 according to the invention that is configured for performing the simultaneous mapping of B₀ and B₁⁺ inhomogeneities. It comprises for instance:
- an imaging system 204, e.g. an MRI scanner, for imaging a biological object 210, said imaging system 204 being configured for performing an MRI pulse sequence 10 and for acquiring an MRI signal resulting from said MRI pulse sequence 10;
- a control unit 201, typically comprising a processor and a memory 202, said control unit 201 being configured for controlling the imaging system 204 for performing said MRI pulse sequence 10, and for processing the acquired MRI signal in order to generate or reconstruct ΔB₀ and B₁⁺ maps;
- one or several displays 203 for displaying said ΔB₀ and B₁⁺ maps reconstructed from said MRI signal.

Preferentially, said MRI system 200 comprises multi-channel phased array coils for parallel transmit imaging of said biological object 210. This enables the MRI system 200 to acquire said (3D) relative coil-cycled maps for estimating the inhomogeneities of B₁⁺.

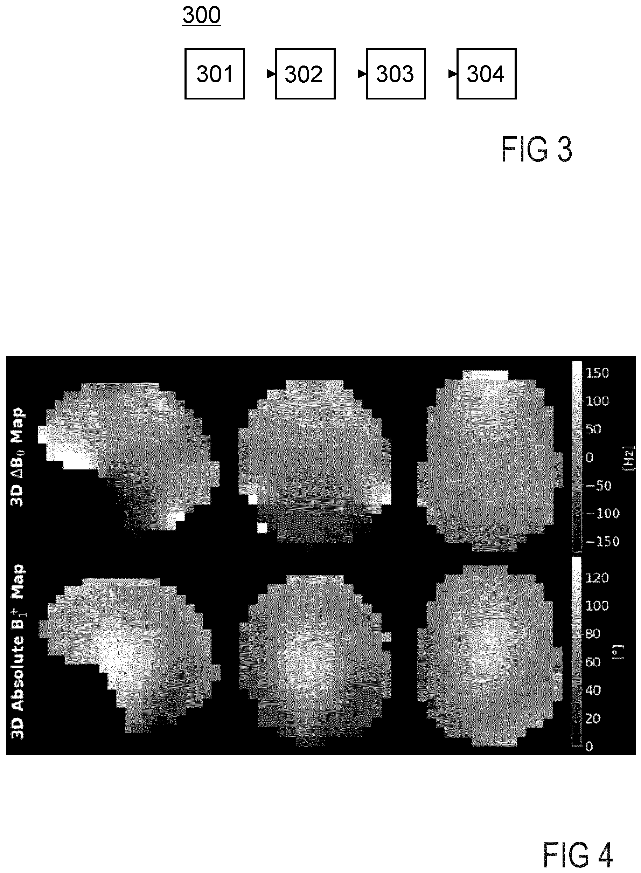

In connection with Figure 3, the steps of a preferred embodiment of the method 300 according to the invention for simultaneously mapping B₀ and B₁⁺ inhomogeneities will be described in more detail hereafter.

At step 301, the MRI system 200 applies the MRI pulse sequence 10 according to the invention to the biological object 210. For instance, it may apply the MRI pulse sequence 10 illustrated in Fig. 1. Typically, the MRI pulse sequence 10 is stored in a memory of the MRI system 200, and its control unit 201 controls the imaging system 204 according to said MRI pulse sequence 10 for performing the simultaneously mapping of B₀ and B₁⁺ inhomogeneities.

At step 302, an MRI signal generated by the biological object 210 and sampled by the readout blocks of the MRI pulse sequence 10 is acquired by the MRI system 200 during each repetition time TR. Typically, the control unit 201 acquires said MRI signal via the imaging system 204, e.g. the scanner of an MRI apparatus. According to the present invention, said MRI signal comprises multiple gradient echoes acquired during each pre-saturation TurboFLASH readout 110, wherein for each echo, the MRI system constructs or generates a pre-saturation image of the biological object 210. Each pre-saturation image comprises voxel-wise information about B₀ that has been acquired from said echo. Said MRI signal further comprises another MRI echo signal acquired during each magnetization-prepared TurboFLASH readout and used by the MRI system for constructing a magnetization-prepared image S_{1,0} of said biological object 210. Each image S_{1,0} comprises voxel-wise information about B₁⁺ that has been acquired from the generated MRI echo signal. Optionally, said MRI signal may comprise a channel-related MRI echo signal acquired during each channel-related MRI readout 152 for constructing a (2D or 3D) relative map of B₁⁺ magnetic field for the biological object 210 for the concerned channel.

At step 303, the MRI system 200, for instance its processing unit 201, is configured for reconstructing, from said magnetization-prepared image S_{1,0} and said pre-saturation images acquired during a same CLUB sequence 100, a ΔB₀ map and an absolute B₁⁺ map of said biological object 210, wherein ΔB₀ represents a map of inhomogeneities of the main magnetic field B₀ with respect to the biological object 210.

In particular, the processing unit 201 may estimate or determine the ΔB₀ map from the phases of S_{0,0}, S_{0,1}, and S_{0,2} by unwrapping the latter with a rapid open source minimum spanning tree algorithm (ROMEO) [4], and correcting offsets with multi-channel phase combination (MCPC-3D-S) [5]. Then, the processing unit 201 might be configured for applying a linear regression fit of the phases against the echo time to estimate or determine the ΔB₀ map as described in the paper of Windischberger et al. [6]. Of course, other known in the art techniques might be used for determining the ΔB₀ map from the pre-saturation images.

In particular, the processing unit 201 may estimate or determine the absolute B₁⁺ map from the ratio of one of said pre-saturation images, e.g. the pre-saturation image S_{0,1} obtained for the first echo, and the magnetization-prepared (S_{1,0}) image using a lookup table generated from Bloch equations and extended phase graph (EPG) [2] simulations to account for T1 relaxation effects. Preferentially, the processing unit 201 might be configured for calculating individual channel-wise B₁⁺ map by scaling, for each channel (or acquisition coil) of the MRI system 200, the absolute B₁⁺ map with the transmission fraction provided by the relative image Sᵣₑₗ of the coil-cycled multi-channel data acquisition sequence 150 obtained for said channel.

At step 304, the MRI system 200, for instance its processing unit 201, is configured for outputting said ΔB₀ and B₁⁺ maps. For instance, the MRI system 200 may display said maps on the display 203, or may use said maps for further processing, like optimizing the pTx of the MRI system 200.

In a preferred embodiment, the MRI pulse sequence 10 is characterized by the following imaging parameters: a first flip angle (β) and a second flip angle (γ) both of 5°, a TF of N=32, echo times TE_{0,0} = 0.69 ms, TE_{0,1} = 2.26 ms, TE_{0,2} = 3.83 ms, and a first echo spacing of 5.52 ms, a second echo spacing of 2.38 ms, a time of repetition TR of 1000 ms, two dummy TR periods, and an acquisition time of approximately 41 s. Preferentially, the third flip angle (τ) is also 5°. Figure 4 illustrates, from the left to the right, a sagittal, coronal, and axial view of an in vivo ΔB₀ map (top) and absolute B₁⁺ map (bottom) obtained for a brain. These maps were generated with the presently described CLUB-Sandwich sequence illustrated in Fig. 1, when using a nonselective broad-band full-passage hyperbolic secant saturation pulse, a linear phase-encoding, a RF spoiling, and the above-mentioned imaging parameters. According to the present invention, the MRI pulse sequence 10, in particular the CLUB sequence 100, might be configured for 2D or 3D imaging or mapping of the ΔB₀ and (absolute or relative) B₁⁺ map.

To conclude, the present invention proposes a simultaneous mapping of a biological object 210, like a brain, based on the use of a TurboFLASH readout wherein multiple GRE readouts have been integrated in the pre-saturation segment (i.e. in said first element 110) of the acquisition (i.e. of said CLUB sequence 100). This technique enables to reduce the preparation time required for the design of pTx pulses used in UHF imaging. Additionally, the simultaneous mapping reduces the number of acquisitions and the challenges it implies (interscan motion and acquisition time). Finally, the maps obtained according to the present invention further enable to retrospectively correct MRI images of the biological object and/or optimize the pTx.

### List of citations

[1] Herrler J, Liebig P, Gumbrecht R, et al. Fast online-customized (FOCUS) parallel transmission pulses: A combination of universal pulses and individual optimization. Magn Reson Med. 2021;85(6):3140-3153. doi:10.1002/mrm.28643.
[2] Weigel M. Extended phase graphs: Dephasing, RF pulses, and echoes - pure and simple. J Magn. Reason. Imaging. 2015;41(2):266-295. doi:10.1002/jmri.24619.
[3] Kent JL, Dragonu I, Valkovič L, Hess AT. Rapid 3D absolute B1+ mapping using a sandwiched train presaturated TurboFLASH sequence at 7 T for the brain and heart. Magn Reson Med. 2023;89(3):964-976. doi:10.1002/mrm.29497
[4] Dymerska B, Eckstein K, Bachrata B, et al. Phase unwrapping with a rapid opensource minimum spanning tree algorithm (ROMEO). Magn Reson Med. 2021;85(4):2294-2308. doi:10.1002/mrm.28563
[5] Eckstein K, Dymerska B, Bachrata B, et al. Computationally Efficient Combination of Multi-channel Phase Data From Multi-echo Acquisitions (ASPIRE). Magn Reson Med. 2018;79(6):2996-3006. doi:10.1002/mrm.26963
[6] Windischberger C, Robinson S, Rauscher A, Barth M, Moser E. Robust field map generation using a triple-echo acquisition. J Magn Reson Imaging. 2004;20(4):730-734. doi:10.1002/jmri.20158 [Weigel 2015] Weigel M. Extended phase graphs: Dephasing, RF pulses, and echoes - pure and simple. J Magn Reson Imaging. 2015;41(2):266-295. doi:10.1002/jmri.24619

## Claims

1. MRI method (300) for simultaneous mapping of B₀ and B₁⁺ inhomogeneities, said MRI method (300) comprising:
- performing (301), by an MRI system (200), an MRI pulse sequence (10) configured for imaging a biological object (210), said MRI pulse sequence (10) comprising a saturation TurboFLASH data acquisition sequence, hereafter satTFL, for absolute B₁⁺ mapping, wherein said satTFL sequence comprises at least three temporally successive elements, namely
- a first element (110) that is a pre-saturation TurboFLASH element, followed by
- a second element (120) that is a magnetization preparation element, followed by
- a third element (130) that is a magnetization-prepared TurboFLASH element,
wherein the first element comprises a flip angle RF excitation pulse β (111), called hereafter the first flip angle pulse, and an associated pre-saturation TurboFLASH readout (112), the second element (120) comprises a RF excitation pulse α (121), and the third element (130) comprises a flip angle RF excitation pulse γ (131), called hereafter the second flip angle pulse, and an associated magnetization-prepared TurboFLASH readout (132) for acquiring a magnetization-prepared image S_{1,0}; **characterized in that**
- said associated pre-saturation TurboFLASH readout (112) comprises an acquisition of multiple echoes for ΔB₀ mapping, wherein, for each echo, a respective pre-saturation image for ΔB₀ mapping is acquired, resulting thus in a modified satTFL sequence called hereafter "CLUB" sequence (100);
- a ΔB₀ map and a B₁⁺ map of said biological object (210) are determined (303) from said magnetization-prepared image S_{1,0} and said pre-saturation images;
- the ΔB₀ and B₁⁺ maps are outputted (304).

2. MRI method (300) according to claim 1, comprising using parallel transmission acquisition, hereafter pTx, for imaging said biological object (210), wherein the MRI pulse sequence (10) comprises, preceding the CLUB sequence (100), a coil-cycled multi-channel data acquisition sequence (150) for acquiring a relative image for each acquisition coil or channel of the MRI system (200), wherein, for each channel, the MRI method further comprises calculating a respective channel-related B₁⁺ map by scaling said B₁⁺ map with a transmission fraction factor calculated voxel-wise from the relative image obtained for the concerned channel.

3. MRI method (300) according to claim 1 or 2, wherein said multiple echoes are three monopolar echoes.

4. MRI method (300) according to one of the claims 1 to 3, wherein the ΔB₀ map is determined or calculated from the phases of the pre-saturation images.

5. MRI method (300) according to claim 2, wherein the B₁⁺ map is an absolute volumetric flip angle map obtained from a ratio of one of said pre-saturation images and the magnetization-prepared image S_{1,0} using a lookup table generated from Bloch equations and extended phase graph simulations to account for T1 relaxation effects.

6. MRI method (300) according to claim 1, wherein P dummy CLUB sequences are acquired prior to the CLUB sequence (100) that is used for mapping simultaneously ΔB₀ and B₁⁺, wherein P is a strictly positive integer.

7. MRI method (300) according to one of the claims 1 to 6, comprising accelerating the MRI pulse sequence (10) by means of an undersampling technique for generating the pre-saturation images and the magnetization-prepared image S_{1,0}, and determining the ΔB₀ and B₁⁺ maps from the generated images.

8. MRI method (300) according to one of the claims 1 to 7, comprising running the MRI pulse sequence (10) with 2D or respectively 3D spatial encoding for outputting 2D or respectively 3D ΔB₀ and B₁⁺ maps .

9. MRI system (200) configured for carrying out the steps of the MRI method (300) according to one of the claims 1-8.

10. MRI system (200) according to claim 9, comprising multi-channel phased array coils for parallel transmit imaging of said biological object (210).
